# EUROPEAN PATENT APPLICATION

(11) **EP 0 768 711 A2**
(43) Date of publication of application: **16.04.1997**
(21) Application number: 96307190.7
(22) Date of filing: 01.10.1996
(51) Int. Cl.: H01L 23/473, H01L 23/31

(54) **Microelectronic package with device cooling**

(30) Priority: 13.10.1995 US 542995
(71) Applicant: AT&T Corp., New York, NY 10013-2412 (US)
(72) Inventor: Weld, John David, Succasunna, New Jersey 07876 (US)
(74) Representative: Johnston, Kenneth Graham

(57) **Abstract**

A microelectronics package has improved device cooling. The package includes a lead frame defining an upper and lower surface. An active electronic device, such as an integrated circuit, is positioned above the upper surface of the lead frame. An encapsulating package is molded around both the lead frame and the active electronic device to form the microelectronic package. A cooling tube is integrally molded within the encapsulating package and typically formed of a thermally conductive material such as copper. A cooling fluid, such as air or a liquid, can be moved through the cooling tube for discharging the heat generated by the active electronic device.

## Description

### Field Of The Invention

This invention relates to a microelectronic package with improved device cooling, and more particularly to a microelectronic package having a lead frame, an active electronic device, and an encapsulated package molded around the lead frame and the active electronic device with improved cooling of the active electronic device.

### Background Of The Invention

Microelectronic packages are continuously increasing in computational capacity and performance through increased circuit density and improved sub-micron circuit technologies, increased input-output capabilities, multi-chip module technology, and a larger integrated circuit chip relative to the size of the package. With this increased performance, there is an increase in the power density, resulting in an increase in the operating temperature of the package. It is well known by those skilled in the art that the reliability of a package is directly related to its operating temperature. The optimum performance of a microelectronic package is obtained only when the heat generated by a chip or plurality of chips (i.e., an active electronic device) is efficiently removed.

Some of these electronic packages include a lead frame with an upper and lower surface and an active electronic device, such as an integrated circuit or chips mounted on a silicon die and positioned above and attached to the upper surface of the lead frame with a thermally conductive adhesive. An encapsulating package is molded around the lead frame and chip and forms a typically substantially flat, rectangular configured microelectronic package. In some applications, cooling fins are mounted on top of the package by a heat conductive adhesive and acts as a heat sink. Typically air is blown over the fins. In this type of microelectronics package, approximately 94% of the heat generated by the chips propagates into the silicon die towards a die adhesive and the lead frame, with the remaining 6% propagating into the epoxy molding compound layer adjacent the chips and forming the encapsulating package.

Typical package designs place the chips above the lead frame so that when the package is mounted onto a circuit board, the high heat side of the package faces the circuit board. With a typical 0.020 inch stand-off of the package from the circuit board, the majority of the heat generated into the electronics package migrates towards the small gap between the electronics package and the circuit board. Air cooling is accomplished by blowing with forced flow, or using the natural buoyancy-induced convective flow of air.

However, the low thermal capacity of the air requires a large volumetric air flow to adequately cool a microelectronic package. Heat sinks sometimes are mounted on the outside surface of the package to increase the package surface area for cooling. Sometimes the heat sinks may be metallic, conductive dies positioned within the package. For example, one thermal management technique includes a molded-end heat slug inserted in the package. The slug is a solid material having a higher thermal conductivity than the epoxy molding compound forming the body of the package. Typically, the heat slug can be aluminum or copper and forms a direct heat conduction path to the surface of the package. Air cooling is then used to expel the heat away from the slug.

This type of arrangement is expensive and difficult to manufacture and does not always provide an acceptable means for reducing the generated heat.

### Summary Of The Invention

The foregoing problems are overcome with the microelectronic package which includes improved device cooling of the present invention. The microelectronic package includes a lead frame defining an upper and lower surface. An active electronic device, such as an integrated circuit, is positioned above and attached to the upper surface of the lead frame with a thermally conductive adhesive. An encapsulating package, such as formed from an epoxy molding compound is molded around the lead frame and active electronic device and forms the microelectronic package. A cooling tube can be integrally molded within the encapsulating package. A cooling fluid is delivered through the cooling tube. The cooling fluid could be air or refrigerant or some other liquid.

In one aspect of the present invention, the cooling tube is mounted in spaced relation above the active electronic device. In still another aspect of the present invention, the cooling tube is mounted against a lead frame opposite the active electronic device.

The active electronic device can be one or more integrated circuits, and in a preferred aspect of the present invention, the cooling tube is formed in a serpentine configuration within the package. The cooling tube is formed of a thermally conductive material such as copper or aluminum. The cooling tube typically has a diameter of about 0.025 inches and an inner diameter of about 0.015 inches. The cooling tube has two ends that extend outward from an edge face of the package.

### Description Of The Drawings

The advantages of the present invention will be appreciated more fully from the following description, with references to the accompanying drawings in which:

Figure 1 is an isometric view of a microelectronic package with two cooling tubes molded within the package, one suspended above the active electronic device and one positioned below but in contact with the lead frame.

Figure 2 is an exploded isometric view of the microelectronic package of Figure 1 showing placement of the cooling tubes with regard to other components of the package.

Figure 3 is a schematic sectional view of the microelectronic package of Figure 1 and showing schematically two possible cooling systems.

Figure 4 is a schematic plan view of the microelectronic package of Figure 1 showing the cooling tube positioned relative to the lead frame.

### Detailed Description Of The Invention

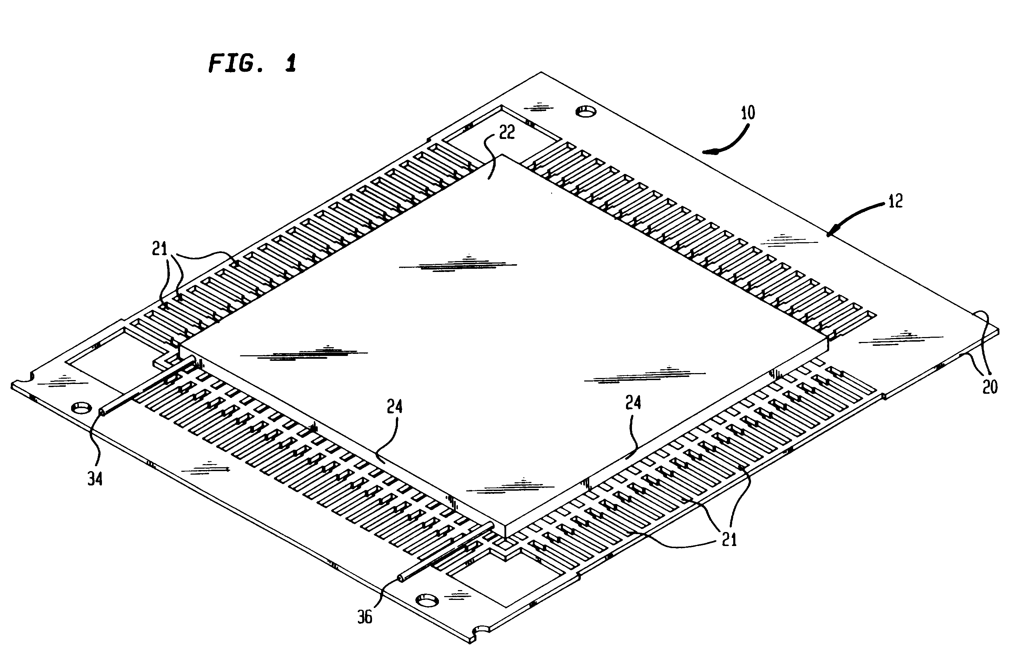

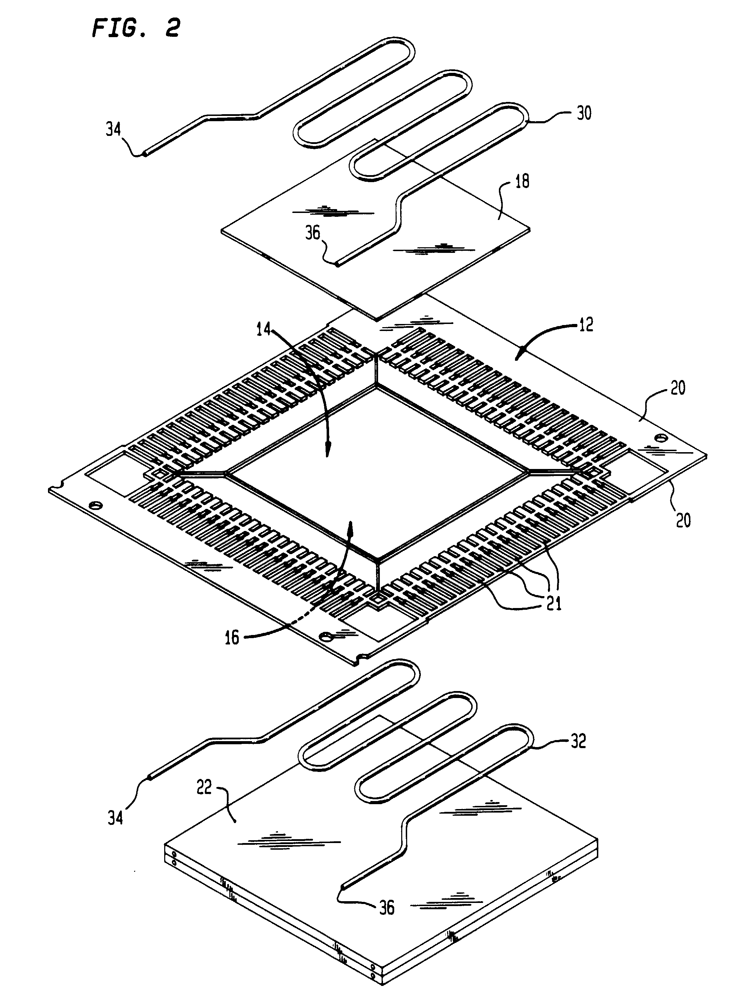

Referring now to Figure 1, there is illustrated generally at 10 a microelectronic package of the present invention having improved cooling of an active electronic device, such as an integrated circuit or series of chips. Figure 2 illustrates an exploded view of the various components of this improved microelectronic package **10**. As illustrated, a lead frame die paddle **12** has top and bottom surfaces **14**, **16** and receives the active electronic device on its top surface **14**. Typically, the active electronic device **18** is a multi-chip module on a silicon substrate. The device **18** can include several active chips or integrated circuits bonded to the silicon substrate. For purposes of clarity, the active electronic device **18** will be referred to hereafter as a chip. The lead frame **12** includes a substantially planar, peripheral portion **20** extending outward from the chip **18** to form a plurality of leads **21** that connect to a circuit board. An epoxy molding compound body (package) **22** is molded over the lead frame and forms the substantially flat, rectangular package **10** having side faces **24** as illustrated. Although a rectangular configured package **10** is illustrated and preferred, the package **10** can be almost any configuration desired by those skilled in the art.

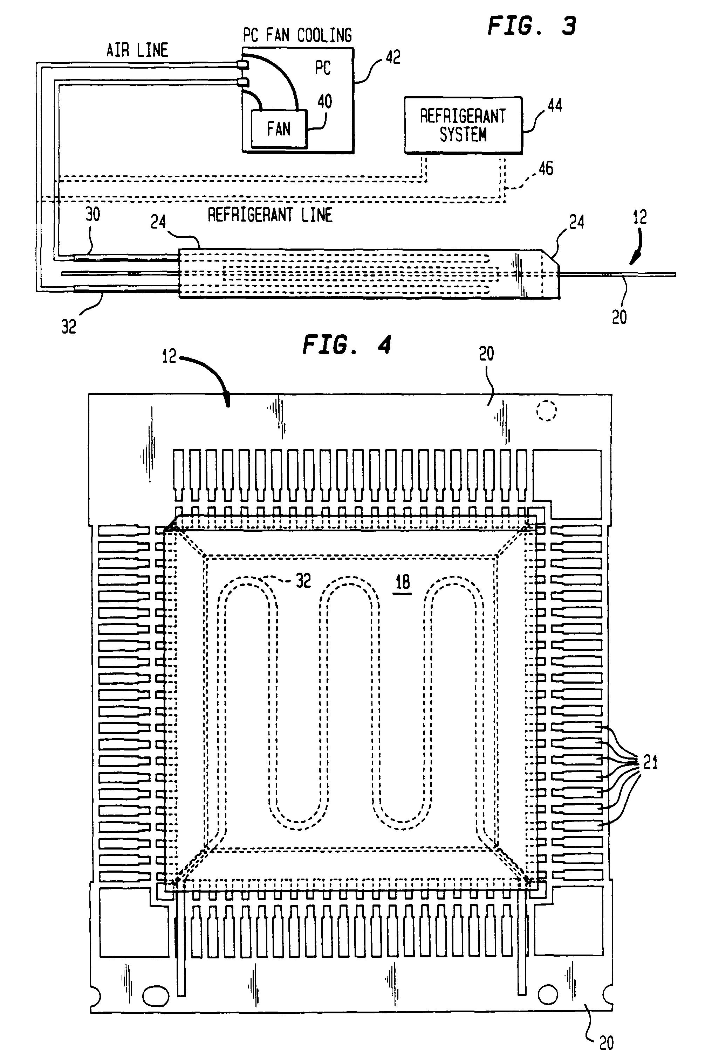

In accordance with the present invention, at least one cooling tube **30** is integrally molded within the encapsulating package in a typically serpentine manner as illustrated. The cooling tube **30** is formed of a thermally conductive material, such as copper or aluminum, and can be about 0.025 inches outer diameter and about 0.015 inches inner diameter. In one aspect of the present invention, the cooling tube **30** is spaced from the top surface **14** of the lead frame **12** and chip **18** as shown in Figures 3 and 4. During manufacture, the cooling tube **30** is typically cantilevered over the chip **18** and supported by inserts in the mold or supporting elements on the lead frame (not shown). Then the epoxy molding compound is molded over the cooling tube **30**, lead frame **12** and chip **18**.

In another aspect of the present invention, a second cooling tube **32**, either singularly or in combination with the other cooling tube **30** is placed on the back side and mounted adjacent and preferably against the lead frame on the opposite side of the chip **18**. In either configuration, however, the cooling tubes **30**, **32** have two ends **34, 36** that extend outward from a side face **24** of the package **10**. The illustrated figures show the two cooling tubes **30, 32** in the two locations as described above. Because the cooling tube **30** is formed from a high heat conductive material, such as copper or aluminum, heat generated by the integrated circuit is conducted through the cooling tube **30** and removed from the package **10**.

In a preferred aspect of the present invention, a cooling fluid is pumped through the cooling tube **30**. The cooling fluid can be air such as provided by a normal fan **40** used in a personal computer **42**, shown schematically in Figure 3. In still another aspect of the present invention, the cooling fluid can be a liquid, such as water, or even a refrigerant. As shown schematically in Figure 2, the refrigerant could be cycled by a refrigerant system **44** with flash vaporation and act as a two-leg natural convection loop so that the refrigerant flows through the refrigerant line, indicated by dotted line **46** without the need for any refrigerant pump. The heat generated by the chip **18** will provide part of the convective loop power necessary for moving the refrigerant.

It should be understood that the foregoing description of the invention is intended merely to be illustrative thereof and that other embodiments, modifications, and equivalents may be apparent to those skilled in the are without departing from its spirit.

## Claims

1. A microelectronic package with improved device cooling comprising
a lead frame defining an upper and lower surface,
an active electronic device positioned above the upper surface of the lead frame,
an encapsulating package molded around the lead frame and the active electronic device and forming the microelectronic package, and
a cooling tube integrally molded within the encapsulating package.

2. A microelectronic package with improved device cooling comprising
a lead frame defining an upper and lower surface,
an active electronic device positioned above the upper surface of the lead frame,
an encapsulating package molded around the lead frame and the active electronic device and forming the microelectronic package, and
a cooling tube integrally molded within the encapsulating package, wherein said cooling tube is formed of a thermally conductive material and positioned in one of two heat discharge positions selected from a position spaced above the electronic device and a positon mounted against the lead frame opposite the active device.

3. The package according to claim 1 or 2, including means for delivering a cooling fluid through the cooling tube.

4. The package according to claim 3, wherein the cooling fluid is air, or a refrigerant.

5. The package according to claim 1, wherein the cooling tube is mounted in spaced relation either above the active electronic device, or against the lead frame opposite the active electronic device.

6. The package according to 1 or 2, wherein said encapsulating package is formed from an epoxy molding compound.

7. The package according to claim 1 or 2, wherein said active electronic device comprises at least one integrated circuit.

8. The package according to claim 1 wherein said cooling tube is formed in a serpentine configuration within the encapsulating package.

9. The package according to claim 1 or 2, wherein said cooling tube is formed of a thermally conductive material, for example copper.

10. The package according to claim 1 or 2, wherein said cooling tube includes an outer diameter of about 0.025 inches and an inner diameter of about 0.015 inches.

11. The package according to claim 1 or 2, wherein said encapsulating package forms a substantially flat, rectangular configured package having at least one edge face, wherein said cooling tube has two ends extending outward from an edge face.
